# EUROPÄISCHE PATENTANMELDUNG

(11) **EP 1 251 192 A2**
(43) Veröffentlichungstag der Anmeldung: **23.10.2002**
(21) Anmeldenummer: 02008477.8
(22) Anmeldetag: 15.04.2002
(51) Int. Cl.: C23C 28/00, C23C 10/28, C23C 16/26, H05B 3/40

(54) **Verfahren zum Herstellen eines Heizkörpers und Heizkörper**

(30) Priorität: 20.04.2001 DE 10119348
(71) Anmelder: E.G.O. Elektro -Gerätebau GmbH, 75038 Oberderdingen (DE)
(72) Erfinder: Riffel, Michael, Dr., 75038 Oberderdingen (DE); Ose, Lutz, Dr., 75447 Sternenfels (DE); Weber, Jürgen, 75056 Sulzfeld (DE); Schinko, Herbert, 75038 Oberderdingen (DE)
(74) Vertreter: Schöndorf, Jürgen

(57) **Zusammenfassung**

Zur Verbesserung der Eigenschaften eines insbesondere elektrisch beheizten Heizkörpers, beispielsweise eines Rohrheizkörpers, wird vorgeschlagen, die Oberfläche zunächst korrosionsbeständig zu machen und anschließend mit einer anlagerungsverhindernden Schicht zu versehen. Die Kombination aus der korrosionsbeständigen Oberfläche mit der anlagerungsverhindernden Schicht führt zu besonders günstigen Ergebnissen, da die anlagerungsverhindernde Schicht die Tendenz hat, die Korrosionseigenschaften der metallischen Oberfläche zu verschlechtern.

## Beschreibung

Die Erfindung geht aus von einem Heizkörper, mit dem eine Flüssigkeit erwärmt werden soll. Es ist bekannt, dass bei solchen Heizkörpern, die beispielsweise elektrisch heizen,die Gefahr der Korrosion besteht. Aus diesem Grunde werden die Oberflächen der Heizkörper korrosionsbeständig gemacht, entweder durch eine entsprechende Auswahl des Materials oder durch eine nachträgliche Behandlung, beispielsweise eine Beschichtung.

Bei Heizkörpern zum Erhitzen von Flüssigkeiten, insbesondere Wasser, besteht weiterhin das Problem, dass sich an der Oberfläche des Heizkörpers mechanische Verunreinigungen absetzen, beispielsweise Kalk, Schmutz, Waschmittelreste oder dergleichen. Um dies zu verhindern, ist auch schon vorgeschlagen worden, die Oberfläche mit einer Beschichtung zu versehen, die das Anhaften von Verunreinigungen erschwert.

Weiterhin ist es bekannt, eine reibungsvermindernde Schicht dadurch herzustellen, dass diamantähnliche Kohlenstoffschichten aufgebracht werden. Diese Art der Beschichtung ist in erster Linie bei Gleitlagern bekannt (EP 22 285).

Auch für den Schutz gegenüber metallischen Anhaftungen von Schweiß-und Lötprozessen ist eine Anti-Haft-Beschichtung bekannt, die eine diamantartige Kohlenstoffschicht ist (WO 99/60183). Schichten dieser Art werden auch als DLC (**D**ia-mant **L**ike **C**arbon) bezeichnet.

Der Erfindung liegt die Aufgabe zugrunde, einen Heizkörper zu schaffen, der bei der Erwärmung von Flüssigkeiten sowohl korrosionsbeständig als auch unempfindlich gegenüber möglichen Ablagerungen ist.

Zur Lösung dieser Aufgabe schlägt die Erfindung ein Verfahren mit den Merkmalen des Anspruchs 1 sowie einen nach diesem Verfahren hergestellten Heizkörper mit den Merkmalen des Anspruchs 13 vor. Weiterbildungen der Erfindung sind Gegenstand von Unteransprüchen.

Die Erfinder der vorliegenden Anmeldung haben herausgefunden, dass eine anlagerungsvermindernde Beschichtung, die für die Verhinderung von Anlagerungen besonders wichtig ist, vollkommen überraschenderweise die Korrosionseigenschaften metallischer Oberflächen verschlechtert. Daher schlagen sie in der vorliegenden Anmeldung eine Kombination aus der korrosionsbeständigen Oberfläche des Heizkörpers und der anlagerungsverhindernden Beschichtung vor.

Die Korrosionsbeständigkeit der Oberfläche des Heizkörpers kann beispielsweise dadurch verwirklicht werden, dass der Heizkörper aus einem hochlegierten Edelstahl hergestellt wird. Dieser weist von Natur aus eine ausreichende Korrosionsbeständigkeit auf, die auch durch die anlagerungsvermindernde Beschichtung nicht wesentlich verschlechtert wird.

Es ist jedoch ebenfalls möglich und wird von der Erfindung vorgeschlagen, dass der Heizkörper aus einem niedrig legierten Edelstahl hergestellt wird, so dass dann die Korrosionsbeständigkeit durch eine Bearbeitung beispielsweise mit Nickel hergestellt wird. Nickel kann beispielsweise elektrolytisch aufgebracht werden. Eine besonders günstige Verbindung mit der Oberfläche des Heizkörpers wird dann dadurch erreicht, dass der Heizkörper erhitzt wird, so dass das Nickel thermisch eindiffundieren kann.

Die anlagerungsvermindernde Schicht kann in Weiterbildung der Erfindung durch Aufdampfen aufgebracht werden, insbesondere durch ein chemisches Verdampfen im Vakuum. Diese Art der Aufdampfung wird häufig auch als CVD bezeichnet.

In Weiterbildung der Erfindung kann vorgesehen sein, dass als anlagerungsverhindernde Schicht eine Schicht aus einem amorphen Kohlenstoff-Wasserstoff-Netzwerk verwendet wird. Insbesondere kann die anlagerungsverhindernde Schicht einen Kohlenstoffanteil von etwa 70 bis 95 % und einen Wasserstoffanteil von etwa 5 bis 30 % aufweisen.

Erfindungsgemäß kann in Weiterbildung vorgesehen sein, dass die erwähnte Schicht dotiert ist, wobei die Dotierung aus 1 bis 40 % Silizium, 1 bis 40 % Fluor, 1 bis 40 % Sauerstoff oder einer Kombination dieser Elemente besteht.

In Weiterbildung der Erfindung kann vorgesehen sein, dass die anlagerungsverhindernde Schicht eine Dicke von 0,1 bis 10 µm aufweist.

Die Erfindung schlägt in Weiterbildung vor, dass die Oberflächenrauhigkeit auf mindestens 90 % der Oberfläche kleiner als 3 µm sein kann.

Die Erfindung schlägt ebenfalls einen Heizkörper mit den im Anspruch 13 genannten Merkmalen vor. Bei dem Heizkörper, bei dem es sich beispielsweise um ein elektrischen Rohrheizkörper handeln kann, kann vorgesehen sein, dass mindestens die Oberfläche aus einem korrosionsbeständigen hochlegierten Edelstahl besteht. Unter Oberfläche ist diejenige Fläche zu verstehen, die mit der zu erhitzenden Flüssigkeit, insbesondere Wasser, in Verbindung gebracht werden soll.

Es kann erfindungsgemäß ebenfalls zur Herstellung der Korrosionsbeständigkeit der Oberfläche vorgesehen sein, dass diese eindiffundiertes Nickel enthält.

Die anlagerungsverhindernde Schicht kann erfindungsgemäß aufgedampft sein, insbesondere durch ein chemisches Ablagerungsverfahren im Vakuum.

Der von der Erfindung vorgeschlagene Heizkörper kann mit Vorteil nach dem beschriebenen Verfahren hergestellt werden, so dass er die durch das Verfahren bewirkten Merkmale aufweisen kann.

Weitere Merkmale, Einzelheiten und Vorzüge der Erfindung ergeben sich aus Beschreibung eines möglichen Ausführungsbeispiels.

Ein Rohrheizkörper wird aus einem relativ niedrig legierten Edelstahl z. B. 1.4541 hergestellt. Danach wird eine Nickelschicht elektrolytisch aufgebracht. Diese ist von Natur aus nicht absolut dicht, wird daher thermisch nachbehandelt. Durch die thermische Nachbehandlung diffundiert das Nickel in die Stahloberfläche ein. Die Dicke der elektrolytischen Nickelschicht liegt zwischen etwa 15 und etwa 25 µm. Danach wird der Rohrheizkörper gefüllt und fertig bearbeitet.

Anschließend wird eine anlagerungsverhindernde Schicht in folgender Weise aufgebracht. Mit einem chemischen Verdampfungsprozess wird eine amorphe Kohlenwasserstoffstruktur aufgebracht, die anlagerungsverhindernde Eigenschaften aufweist. Eine solche Art der Beschichtung ist beispielsweise aus EP 222 085 bekannt.

Die Kombination aus der korrosionsbeständigen Nickelschicht und der anlagerungsverhindernden zusätzlichen Schicht hat sich als besonders vorteilhaft herausgestellt, da die Erfinder der vorliegenden Erfindung herausgefunden haben, dass die anlagerungsverhindernde Schicht überraschenderweise die Korrosionseigenschaften einer normalen Edelstahloberfläche verschlechtert. Diese Verschlechterung hängt möglicherweise von der Qualität des Wassers ab.

Als hochlegierter Stahl an Stelle der nickeldiffundierten niedrig legierten Oberfläche kommt insbesondere Stahl der Güte 1.4876 oder 2.4858 in Frage.

## Patentansprüche

1. Verfahren zum Herstellen eines Heizkörpers für die Erwärmung von Flüssigkeiten, mit folgenden Verfahrensschritten:
1.1 ein später den Heizkörper bildenden Körper wird aus Edelstahl hergestellt,
1.2 mindestens eine zum Kontakt mit der Flüssigkeit bestimmte Oberfläche des Körpers wird korrosionsbeständig gemacht,
1.3 die korrosionsbeständige Oberfläche wird mit einer anlagerungsverhindernden Schicht versehen.

2. Verfahren nach Anspruch 1, bei dem der Heizkörper aus einem hochlegierten Edelstahl hergestellt wird, der die Korrosionsbeständigkeit mit sich bringt.

3. Verfahren nach Anspruch 1 oder 2, bei dem der Heizkörper durch eine Bearbeitung mit Nickel korrosionsbeständig gemacht wird.

4. Verfahren nach Anspruch 3, bei dem Nickel elektrolytisch aufgebracht wird.

5. Verfahren nach Anspruch 3 oder 4, bei dem Nickel thermisch eindiffundiert wird.

6. Verfahren nach einem der vorhergehenden Ansprüche, bei dem die anlagerungsverhindernde bzw. reibungsvermindernde Schicht durch Aufdampfen aufgebracht wird.

7. Verfahren nach einem der vorhergehenden Ansprüche, bei den die reibungsvermindernde bzw. anlagerungsverhindernde Schicht im Vakuum durch ein chemisches Verdampfen aufgebracht wird.

8. Verfahren nach einem der vorhergehenden Ansprüche, bei dem als anlagerungsverhindernde Schicht eine Schicht aus einem amorphen KohlenstoffWasserstoff-Netzwerk verwendet wird.

9. Verfahren nach Anspruch 8, bei dem die anlagerungsverhindernde Schicht einen Kohlenstoffanteil von etwa 70 bis 95 % und einen Wasserstoffanteil von etwa 5 bis 30 % aufweist.

10. Verfahren nach einem der vorhergehenden Ansprüche, bei dem die anlagerungsverhindernde Schicht dotiert ist, wobei die Dotierung aus etwa 1 bis 40 % Silizium, 1 bis 40 % Fluor, 1 bis 40 % Sauerstoff oder einer Kombination dieser Elemente besteht.

11. Verfahren nach einem der vorhergehenden Ansprüche, bei dem die anlagerungsverhindernde Schicht eine Dicke von etwa 0,1 bis 10 µm aufweist.

12. Verfahren nach einem der vorhergehenden Ansprüche, bei dem die Oberflächenrauhigkeit auf mindestens 90 % der Oberfläche kleiner als etwa 3 µm ist.

13. Heizkörper für Flüssigkeiten, insbesondere Wasser, mit
13.1 einer metallischen zum Kontakt mit der Flüssigkeit bestimmten Oberfläche, die
13.2 korrosionsbeständig ausgebildet ist, sowie mit
13.3 einer auf der korrosionsbeständigen Oberfläche des Heizkörpers aufgebrachten anlagerungsverhindernden Schicht.

14. Heizkörper nach Anspruch 13, bei dem seine Oberfläche aus einem korrosionsbeständigen hochlegierten Edelstahl besteht.

15. Heizkörper nach Anspruch 13, bei dem die Oberfläche eindiffundiertes Nickel aufweist.

16. Heizkörper nach Anspruch 13 bis 15, bei dem die anlagerungsverhindernde Schicht aufgedampft ist.

17. Verfahren nach Anspruch 16, bei dem die anlagerungsverhindernde Schicht im Vakuum chemisch aufgedampft ist.

18. Verfahren nach einem der vorhergehenden Ansprüche, bei dem die anlagerungsverhindernde Schicht aus einem amorphen Kohlenstoff-Wasserstoff-Netzwerk besteht.

19. Heizkörper nach Anspruch 18, bei dem die anlagerungsverhindernde Schicht einen Kohlenstoffanteil von etwa 70 bis 95 % und einen Wasserstoffanteil von etwa 5 bis 30 % aufweist.

20. Heizkörper nach Anspruch 19, bei dem die anlagerungsverhindernde Schicht dotiert ist, wobei die Dotierung aus 1 bis 40% Silizium, 1 bis 40 % Fluor, 1 bis 40 % Sauerstoff oder einer Kombination dieser Elemente besteht.

21. Heizkörper nach einem der Ansprüche 13 bis 20, bei dem die anlagerungsverhindernde Schicht etwa 0,1 bis 10 µm dick ist.

22. Heizkörper nach einem der Ansprüche 13 bis 21, bei dem die Oberflächenrauhigkeit auf mindestens 90 % der Oberfläche kleiner als 3 µm ist.
